# EUROPEAN PATENT SPECIFICATION

(11) **EP 4 696 199 B1**
(45) Date of publication and mention of the grant of the patent: **09.12.2026**
(21) Application number: 25163368.1
(22) Date of filing: 12.03.2025
(51) Int. Cl.: A47C 7/62, A47C 7/72

(54) **FURNITURE ACCESSORY WITH DETACHABLE CONTROLLER**
MÖBELZUBEHÖR MIT ABNEHMBARER STEUERUNG
ACCESSOIRE DE MEUBLE AVEC DISPOSITIF DE COMMANDE DÉTACHABLE

(30) Priority: 13.08.2024 US 202418802741
(43) Date of publication of application: 18.02.2026
(73) Proprietor: Emomo Tech (Zhejiang) Co., Ltd, Huzhou, Zhejiang 313000 (CN)
(72) Inventor: YAO, CHANGMING, HUZHOU, 313000 (CN); ZHOU, WEI, HUZHOU, 313000 (CN); HU, DASHENG, HUZHO, 313000 (CN); ZHAO, YUSHU, HUZHOU, 313000 (CN); SONG, JING, HUZHOU, 313000 (CN)
(74) Representative: Metida

(56) References cited:
- US-A1- 2021 328 823
- US-A1- 2022 408 925

## Description

### BACKGROUND

The present disclosure relates to furniture accessories. Specifically, the present disclosure relates to furniture accessories including a beverage holder and electrical features such as connections, controls, and chargers.

Over the years, developments in technology-enabled furniture have transformed the concept of a smart home into a practical reality. Furniture equipped with information transmission and control component technology continues to replace traditional furniture items that lack the technical functionality and aesthetic qualities that are desired in today's developing smart home.

D1 (US2022408925A1) discloses furniture-integrated entertainment hubs that provide user interfaces, wireless charging for smart devices, and movable features such as cup holders, with the hub body mostly embedded in the furniture and a control panel accessible for operation.

### BRIEF SUMMARY

The shortcomings of the known furniture accessories are overcome by a furniture accessory according to claim 1.

### BRIEF DESCRIPTION OF THE SEVERAL VIEWS OF THE DRAWINGS

A more particular description will be rendered by reference to exemplary embodiments that are illustrated in the accompanying figures. Understanding that these drawings depict exemplary embodiments and do not limit the scope of this disclosure, the exemplary embodiments will be described and explained with additional specificity and detail through the use of the accompanying drawings in which:
FIG. 1 is an upper, front perspective view of a furniture accessory according to an embodiment;
FIG. 2 is an upper, rear perspective view of a furniture accessory according to an embodiment;
FIG. 3 is a front plan view of a furniture accessory according to an exemplary embodiment;
FIG. 4 is a rear plan view of a furniture accessory according to an exemplary embodiment;
FIG. 5 is a left side plan view of a furniture accessory according to an exemplary embodiment;
FIG. 6 is a right side plan view of a furniture accessory according to an exemplary embodiment;
FIG. 7 is a top plan view of a furniture accessory according to an exemplary embodiment;
FIG. 8 is a bottom plan view of a furniture accessory according to an exemplary embodiment;
FIG. 9 is an upper, front perspective view of a furniture accessory according to an exemplary embodiment;
FIG. 10 is an upper, rear perspective view of a furniture accessory according to an exemplary embodiment;
FIG. 11 is a lower, front perspective view of a furniture accessory according to an exemplary embodiment;
FIG. 12 is a perspective cross-section view of a furniture accessory according to an exemplary embodiment; and
FIG. 13 is a schematic diagram of a furniture item and furniture accessory according to an exemplary embodiment.

Various features, aspects, and advantages of the exemplary embodiments will become more apparent from the following detailed description, along with the accompanying drawings in which like numerals represent like components throughout the figures and detailed description. The various described features are not necessarily drawn to scale in the drawings but are drawn to emphasize specific features relevant to some exemplary embodiments.

The headings used herein are for organizational purposes only and are not meant to limit the scope of the disclosure or the claims. To facilitate understanding, reference numerals have been used, where possible, to designate like elements common to the figures.

### DETAILED DESCRIPTION

Reference will now be made in detail to various exemplary embodiments. Each example is provided by way of explanation and is not meant as a limitation and does not constitute a definition of all possible embodiments.

For purposes of this disclosure, relative terms including, without limitation, "top," "bottom," "rear," "front," "upper," "lower," "above," "below," "within," and the like are used to aid the description of, e.g., configurations of features as shown in the accompanying figures, and otherwise as the disclosure makes clear. Such relative terms do not imply any particular dimension or delineation of or between features except where the disclosure makes clear.

For purposes of this disclosure, terms including, without limitation, "first," "second," "third," and "fourth" are used for descriptive purposes only and without limitation with respect to, e.g., an ordering of process steps, function, or configuration.

For purposes of illustrating features of the embodiments, an exemplary embodiment will now be introduced and referenced throughout the disclosure. It will be understood that this example and other exemplary embodiments described in this disclosure are illustrative and not limiting and are provided for illustrating the exemplary features of a furniture accessory equipped with a power supply.

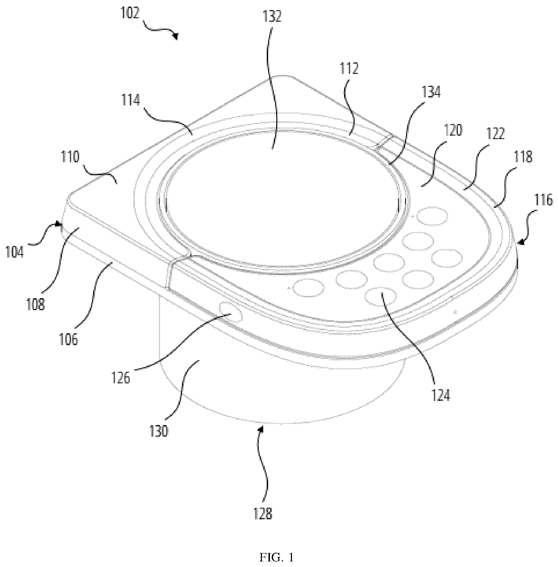

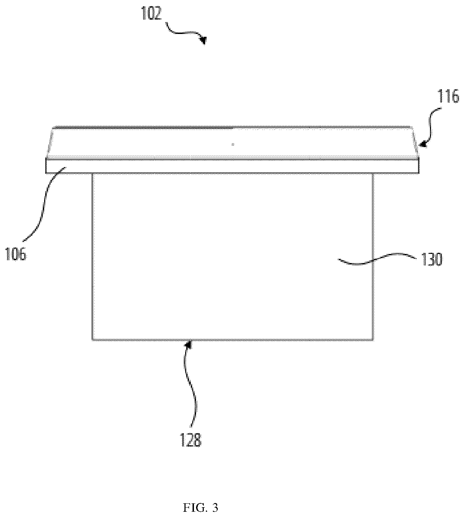

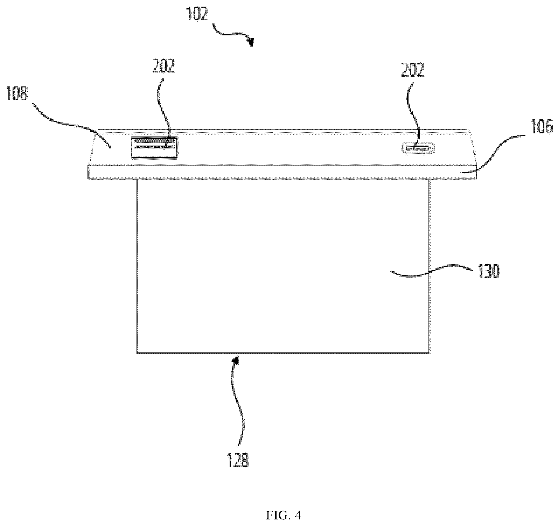

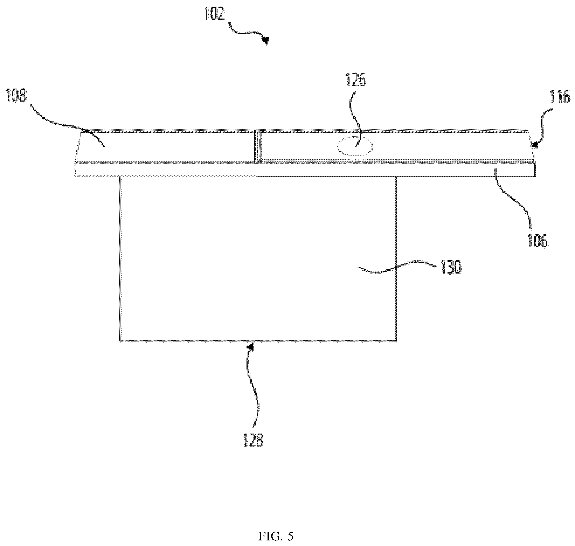

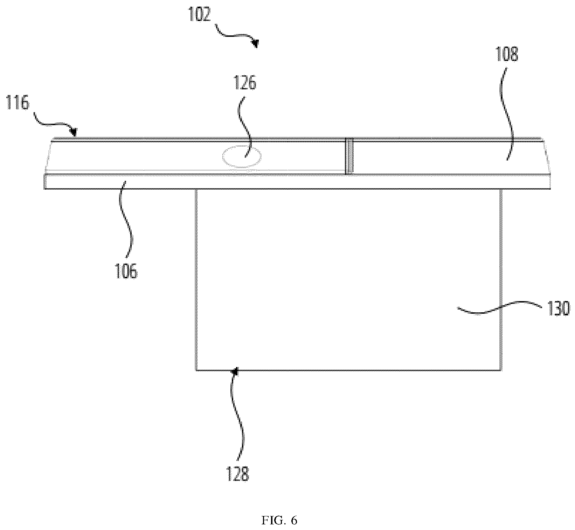

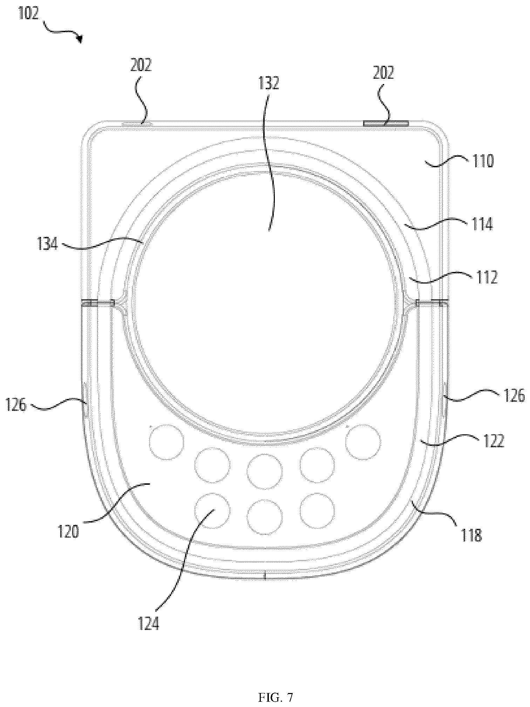

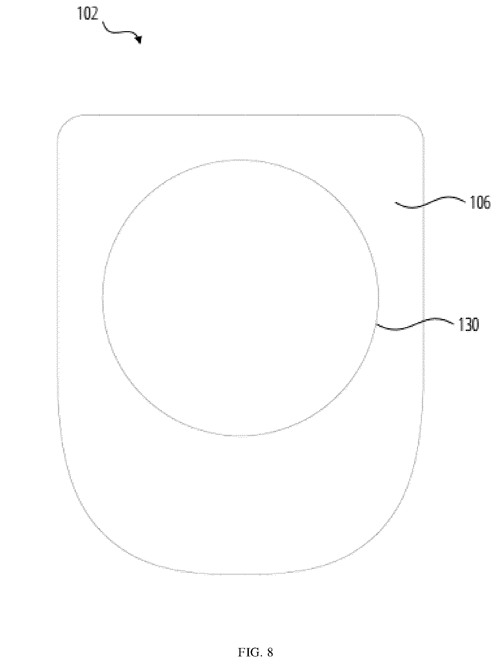

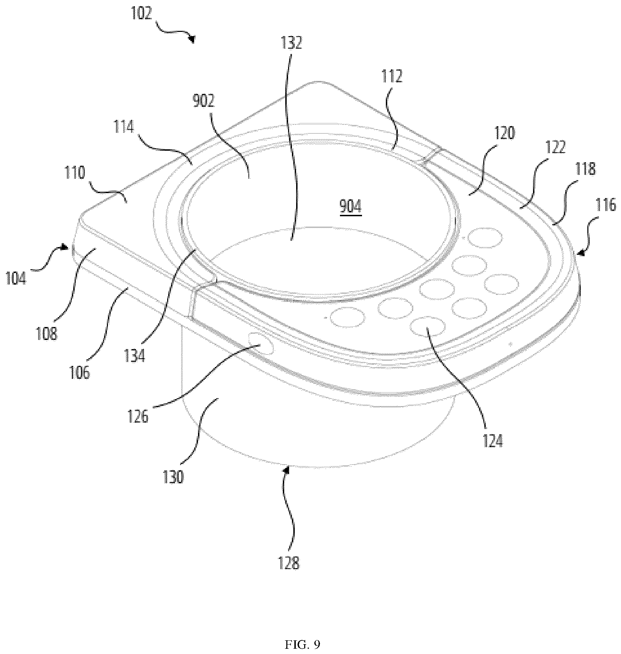

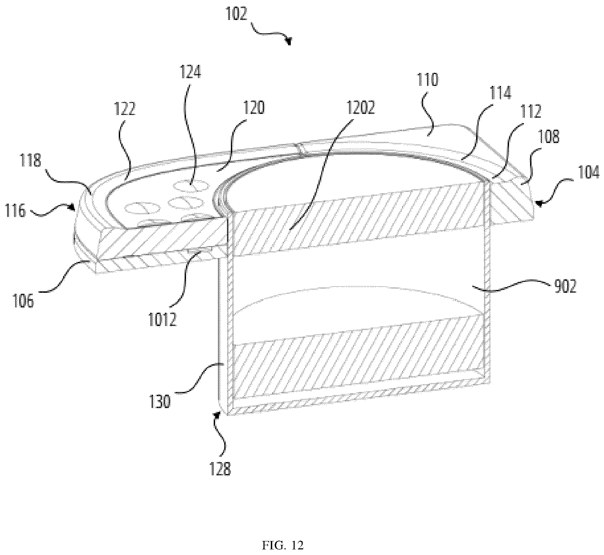

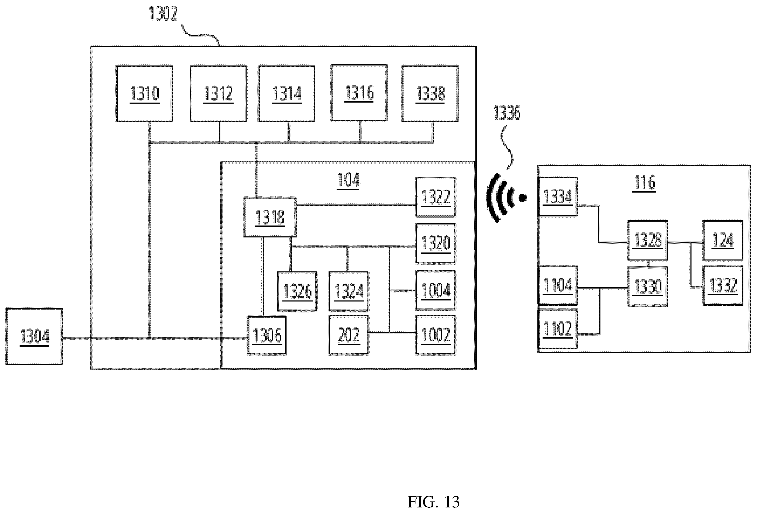

FIG. 1 through FIG. 12 illustrate an exemplary embodiment of a furniture accessory 102. The furniture accessory 102 may be attached to a furniture item 1302 (see FIG. 13) such as, but not limited to, a couch, love seat, chair, or the like. The furniture accessory 102 may also be used in a bed. The furniture accessory 102 may be configured to control various operations of the furniture accessory 102 itself and/or the furniture item 1302 to which the furniture accessory 102 is attached.

The furniture accessory 102 includes, according to the invention, an accessory body 104 and a controller 116 coupled to the accessory body 104. The accessory body 104 may include a body base plate 106 and a body upper portion 108 provided on the body base plate 106. The body upper portion 108 includes, according to the invention, a body first surface 110, a body second surface 112, and may include a body beveled surface 114 connecting the body first surface 110 to the body second surface 112. The body first surface 110 and the body second surface 112 may be substantially parallel. The body second surface 112 is, according to the invention, at a lower level than the body first surface 110 in a vertical direction when the furniture accessory 102 is installed in the furniture item 1302. In other words, the body second surface 112 may be displaced from the body first surface 110 in the vertical direction.

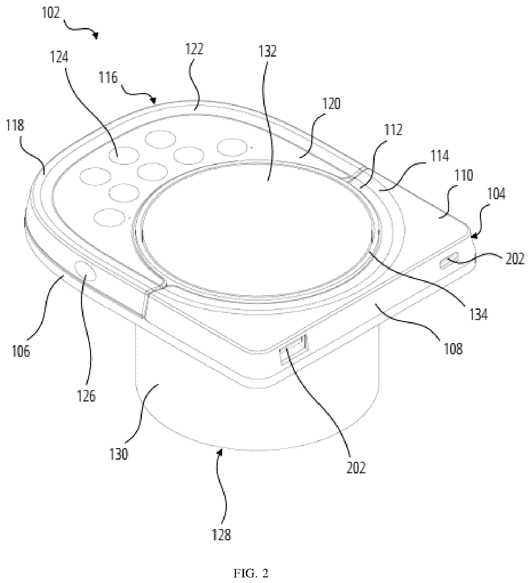

As seen in FIG. 2, the accessory body 104 may further include one or more electrical connectors 202. The electrical connectors 202 may be USB-A, USB-B, or USB-C connectors, or any other type of connector. A user may use the electrical connectors 202 to connect or power devices such phones, tablets, gaming devices, lights, fans, or any other device that may be connected via a cable. Additionally, the electrical connectors 202 may be used as input connectors to receive information from external devices, such as music data to be played via speakers (e.g., as part of a sound system 1316 as shown in FIG. 13) embedded in the furniture item 1302. The electrical connectors 202 are illustrated as being provided in a rear surface of the body upper portion 108, but it will be understood that the electrical connectors 202 are not limited to this location. For example, an electrical connector 202 may be provided on side surfaces of the body upper portion 108, the body first surface 110, the body second surface 112, or the body beveled surface 114, depending on dimensions and available space.

The controller 116 includes, according to the invention, a controller first surface 118, a controller second surface 120, and may include a controller beveled surface 122 connecting the controller first surface 118 to the controller second surface 120. When the furniture accessory 102 is installed in the furniture item 1302 and the controller 116 is coupled to the accessory body 104, the controller second surface 120 is, according to the invention, at a lower level than the controller first surface 118 in a vertical direction. In other words, the controller second surface 120 may be displaced from the controller first surface 118 in the vertical direction. When the controller 116 is coupled to the accessory body 104, the controller first surface 118 may be substantially coplanar with the body first surface 110. Further, when the controller 116 is coupled to the accessory body 104, the controller second surface 120 is, according to the invention, substantially coplanar with the body second surface 112. One or more indents 126 may be provided in the controller 116 to facilitate gripping and holding the controller 116.

The furniture accessory 102 may further include a receptacle 128 that protrudes through the body base plate 106. With specific reference to FIG. 1, FIG. 9, and FIG. 12, the receptacle 128 may include a receptacle outer wall 130, a receptacle inner wall 902, and includes, according to the invention, a receptacle upper rim surface 134. The receptacle upper rim surface 134 is disposed above the body second surface 112 and the controller second surface 120. In other words, the receptacle upper rim surface 134 is displaced from the body second surface 112 and the controller second surface 120 in the vertical direction. According to the invention, the receptacle upper rim surface 134 is substantially coplanar with the body first surface 110 and the controller first surface 118.

The receptacle 128 may further include a movable plate 1202 provided within a cavity 904 defined by the receptacle inner wall 902. The movable plate 1202 has, according to the invention, a plate surface 132. The movable plate 1202 is, according to the invention, movable in a vertical direction between an upper limit and a lower limit. An exemplary embodiment of the mechanism for moving the movable plate 1202 will be explained in further detail below with respect to FIG. 13. In a state in which the movable plate 1202 is at the upper limit of the movable plate 1202 and the controller 116 is coupled to the accessory body 104, the plate surface 132 is, according to the invention, substantially coplanar with the receptacle upper rim surface 134, the body first surface 110, and the controller first surface 118.

When the movable plate 1202 is lowered from the upper limit, the cavity 904 may be employed as a holder for a beverage container such as a cup, can, bottle, or the like. The receptacle outer wall 130, the receptacle inner wall 902, and the movable plate 1202 are depicted as being circular in shape, but it will be understood that this is not intended to be limiting and that other shapes are possible, such as polygonal, elliptical, sawtoothed-pattern, wave-patterned, or other shape.

The movable plate 1202 may further include a charging element 1320 (see FIG. 13), for example embedded within an interior of the movable plate 1202 or provided in the plate surface 132. In an exemplary embodiment, the charging element 1320 may be a contactless charging transmitter configured to provide electrical charge to a device placed on the plate surface 132, such as a cellular phone, tablet, gaming device, or the like. The charging element 1320 may be configured to charge the device via electromagnetic induction. In an aspect, a light or lighting element (not shown) may be positioned on or adjacent to the receptacle upper rim surface 134 such that the lighting element and/or light produced therefrom identifies the position of the receptacle upper rim surface 134 for use a cup holder in dark environments. The light or lighting element (not shown) may also be used to indicate a status of the furniture accessory 102 including, for example, the presence of a mobile device on the plate surface 132 of the movable plate 1202, such as during wireless charging.

The controller 116 may include one or more user inputs 124. The user inputs 124 may include one or more buttons, dials, knobs, switches, sliders, touch controls, or the like. In an exemplary embodiment, the user inputs 124 may be provided on the controller second surface 120. The user inputs 124 may be configured to control functions of the furniture accessory 102 such as raising or lowering the movable plate 1202 or controlling power, lights, heating/cooling elements, or other aspects of the furniture accessory 102. The user inputs 124 may also be configured to control functions of the furniture item 1302, such as reclining, position of a footrest, massage functions, heating functions, volume of music through embedded speakers, or any other functions provided by the furniture item 1302. The controller 116 may also include one or more indicators 1332 configured to provide data about the operation of the controller 116 and/or the furniture item 1302. The indicators 1332 may include any device configured to give information to a user, including, but not limited to, LED lights, digital displays, or screen displays. The indicators 1332 may provide information such as position and/or configuration of the furniture item 1302, temperature of a heating element, information about massage program, position of the movable plate 1202, music volume, or any other suitable information related to operation of the furniture item 1302 and/or the furniture accessory 102. Other exemplary functions for indicators 1332 may be to show a power, charging, or battery status of the controller 116 or the position of user inputs 124 for operation in the dark. Further exemplary functions may relate to a Bluetooth connection, such as a status of the connection.

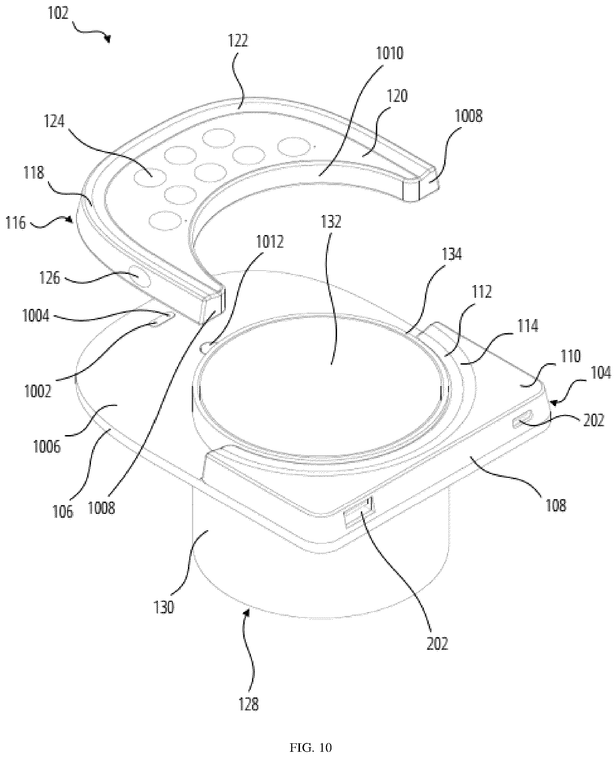

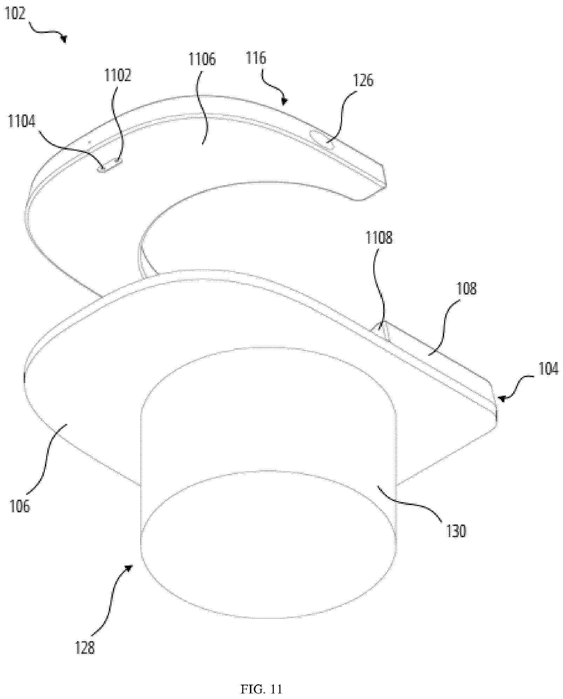

The controller 116 may be detachably coupled to the accessory body 104 (see FIG. 10 and FIG. 11). The controller 116 may couple to the accessory body 104 by one or more magnets or mechanical couplings such as latches, clips, snaps, or the like, or any other suitable attachment mechanisms. Exemplary embodiments of mechanical couplings may include a projection formed on one of the controller 116 and the accessory body 104 and a complementary socket formed on the other of the controller 116 and the accessory body 104.

The controller 116 may include a power storage 1330 (see FIG. 13) configured to supply power to components of the controller 116 when detached. In an exemplary embodiment, the power storage 1330 may be a rechargeable battery or capacitor provided within the controller 116. Alternatively, the power storage 1330 may be removable batteries that can be replaced when depleted.

As seen in FIG. 10, the body base plate 106 may include a one-key retrieval button ("retrieval button 1012") provided on a base plate upper surface 1006. The retrieval button 1012 may operate to, e.g., reset settings of the controller 116 and/or the furniture item 1302 and/or audibly or by any suitable app or technique provide a locator function for finding the controller 116 when detached from the body base plate 106. The body base plate 106 in the exemplary embodiment may also include a body first contact 1002 and a body second contact 1004 provided on the base plate upper surface 1006. The body first contact 1002 and the body second contact 1004 may be connected to a power supply 1306 as explained in detail below with reference to FIG. 13. FIG. 11 shows that the controller 116 may include a controller first contact 1102 and a controller second contact 1104 provided on a controller bottom surface 1106. The controller first contact 1102 and the controller second contact 1104 may be electrically coupled to the power storage 1330. The body first contact 1002, the body second contact 1004, the controller first contact 1102, and the controller second contact 1104 may be configured such that, when the controller 116 is coupled to the accessory body 104, the body first contact 1002 connects to the controller first contact 1102 and the body second contact 1004 connects to the controller second contact 1104 to charge the power storage 1330 from the power supply 1306 provided in the furniture item 1302.

It will be understood that the positions of the body first contact 1002 and the body second contact 1004 are not limited to the base plate upper surface 1006, and that the positions of the controller first contact 1102 and the controller second contact 1104 are not limited to the controller bottom surface 1106. The body first contact 1002, the body second contact 1004, the controller first contact 1102, and the controller second contact 1104 may be provided on alternative surfaces. For example, the controller first contact 1102 and the controller second contact 1104 may be provided on a controller end surface 1008 of the controller 116 (see FIG. 10), and the body first contact 1002 and the body second contact 1004 may be provided on an upper portion end surface 1108 of the accessory body 104. Alternatively, the power storage 1330 of the controller 116 may be charged via electromagnetic induction from a charging element provided in the accessory body 104.

As further seen in FIG. 10, the controller 116 may further include a controller inner surface 1010 contoured to be complementary to a shape of the receptacle outer wall 130. This may allow the controller 116 to fit snugly against the receptacle outer wall 130 when coupled to accessory body 104 in an aesthetically pleasing fashion.

FIG. 13 shows a schematic illustrating the conceptual relationship between components in an exemplary embodiment of a furniture item 1302 and controller 116. It will be understood that FIG. 13 is merely showing one possible conceptual relationship between components and that other possible relationships are possible within the scope and spirit of the disclosure. Further, it will be understood that FIG. 13 does not necessarily demonstrate the physical positioning or configuration of components, and that other components, such as a common power bus, may be present but are not shown in FIG. 13.

As seen in FIG. 13, the furniture item 1302 may include an external connector 1304 such as a plug or AC adapter which may be in electrical communication with the power supply 1306 provided in the accessory body 104. FIG. 13 shows the external connector 1304 connecting to functional units (e.g., 1310, 1312, 1314, 1316, 1338, discussed below) of the furniture item 1302, but it will be understood that in an alternative embodiment, the external connector 1304 is connected directly to the accessory body 104. In this alternate embodiment, the power supply 1306 of the accessory body 104 may be configured to supply power to the various functional units of the furniture item 1302.

The accessory body 104 may further include a functional module 1318 configured to control the various modules and components of the furniture item 1302 and the furniture accessory 102. In an exemplary embodiment, the functional module 1318 may include a processor. As illustrative, but not limiting examples, the furniture item 1302 may include functional function units such as a reclining mechanism 1310 configured to control angle and positioning of various parts of the furniture item 1302 through mechanical actuators. The furniture item 1302 may further include a massage mechanism 1312 including various actuators to provide a massaging action for a user of the furniture item 1302. The furniture item 1302 may further include a temperature control mechanism 1314 including heating or cooling elements configured to soothe or stimulate muscles or for the user's environmental comfort. The furniture item 1302 may also include a sound system 1316 including speakers for playing music or sound from a television, phone, tablet, computer, gaming system, or the like. The furniture item 1302 may also include a light system 1338 to provide light for the user. It will be understood that the functional function units are not limited to these examples, and other functional units are possible within the scope and spirit of the disclosure.

FIG. 13 further shows that the functional module 1318 may be in electrical communication with the body first contact 1002 and the body second contact 1004 in order to control and/or supply electrical power for charging the controller 116. The functional module 1318 may also be in electrical communication with the charging element 1320 in order to control and/or supply electrical power for charging a user device via contactless charging. The functional module 1318 may also be in electrical communication with the electrical connector 202 to control and/or supply electrical power to the electrical connector 202, or to receive signals from a device connected via the electrical connector 202.

The functional module 1318 may also be in electrical communication with a movable plate mechanism 1324. The movable plate mechanism 1324 may be configured to receive control signals from the functional module 1318 for controlling a position of the movable plate 1202. The movable plate mechanism 1324 may include a motor and gear arrangement, such as a direct current (DC deceleration motor), a screw drive motor, or the like.

The accessory body 104 may further include a position detection module 1326 configured to work in conjunction with or independently of the movable plate mechanism 1324 to detect a position of the movable plate 1202. The position detection module 1326 may include components such as optical sensors configured to detect a vertical position with respect to the receptacle inner wall 902. Alternatively or in addition to optical sensors, the position detection module 1326 may include components such as encoders coupled to the motors and/or gears of the movable plate mechanism 1324 to detect a position of the movable plate 1202. The functional module 1318 may be configured to control the movable plate mechanism 1324 to stop movement of the movable plate 1202 if the position detection module 1326 indicates that the movable plate 1202 has met or exceeded predetermined position limits, such as a position upper limit or a position lower limit.

The accessory body 104 may further include an accessory body communication module 1322 in electrical communication with the functional module 1318. The accessory body communication module 1322 may be configured to transmit and/or receive a wireless signal 1336. The accessory body communication module 1322 may be configured to communicate via any applicable wireless communication standard, including, but not limited to, Bluetooth, radio frequency, infrared, wi-fi, or any other suitable standard.

FIG. 13 further shows that the functional module 1318 in the accessory body 104 controls the functional units of the furniture item 1302, but the disclosure is not limited to this embodiment. For example, in an alternative embodiment, the furniture item 1302 may include a separate furniture processor (not shown) that controls the functional function units of the furniture item 1302. The furniture processor may be in wired or wireless communication with the functional module 1318.

FIG. 13 further shows a schematic diagram of the controller 116. The controller 116 may include a controller processor 1328 configured to control operation of the controller 116. As described above, the controller 116 may include the controller first contact 1102 and the controller second contact 1104 configured to connect to the body first contact 1002 and the body second contact 1004 for charging the power storage 1330. The controller processor 1328 may be in electrical communication with the on or more user inputs 124 provided on the controller 116. The controller processor 1328 may receive signals from the user input 124 and interpret and/or relay those signals to a controller communication module 1334 for communicating with the accessory body communication module 1322. Similar to the accessory body communication module 1322, the controller communication module 1334 may be configured for wireless communication via any suitable standard, including, but not limited to, Bluetooth, radio frequency, infrared, wi-fi, or any other suitable standard. The controller communication module 1334 may transmit instructions received via the user inputs 124 to the accessory body communication module 1322 and/or receive information from the accessory body communication module 1322 that is communicated to the user, e.g., via the indicators 1332.

It will be understood that in an exemplary embodiment, the accessory body 104 may not include the accessory body communication module 1322, and a communication module may instead be provided directly in the furniture item 1302. In this embodiment, the controller communication module 1334 would communicate with the communication module of the furniture item 1302 instead of with the accessory body communication module 1322 provided within the accessory body 104.

This disclosure, in various embodiments, configurations and aspects, includes components, methods, processes, systems, and/or apparatuses as depicted and described herein, including various embodiments, sub-combinations, and subsets thereof. This disclosure contemplates, in various embodiments, configurations and aspects, the actual or optional use or inclusion of, e.g., components or processes as may be well-known or understood in the art and consistent with this disclosure though not depicted and/or described herein.

The phrases "at least one", "one or more", and "and/or" are open-ended expressions that are both conjunctive and disjunctive in operation. For example, each of the expressions "at least one of A, B and C", "at least one of A, B, or C", "one or more of A, B, and C", "one or more of A, B, or C" and "A, B, and/or C" means A alone, B alone, C alone, A and B together, A and C together, B and C together, or A, B and C together.

In this specification and the claims that follow, reference will be made to a number of terms that have the following meanings. The terms "a" (or "an") and "the" refer to one or more of that entity, thereby including plural referents unless the context clearly dictates otherwise. As such, the terms "a" (or "an"), "one or more" and "at least one" can be used interchangeably herein. Furthermore, references to "one embodiment", "some embodiments", "an embodiment" and the like are not intended to be interpreted as excluding the existence of additional embodiments that also incorporate the recited features. Approximating language, as used herein throughout the specification and claims, may be applied to modify any quantitative representation that could permissibly vary without resulting in a change in the basic function to which it is related. Accordingly, a value modified by a term such as "about" is not to be limited to the precise value specified. In some instances, the approximating language may correspond to the precision of an instrument for measuring the value. Terms such as "first," "second," "upper," "lower", etc. are used to identify one element from another, and unless otherwise specified are not meant to refer to a particular order or number of elements.

As used herein, the terms "may" and "may be" indicate a possibility of an occurrence within a set of circumstances; a possession of a specified property, characteristic or function; and/or qualify another verb by expressing one or more of an ability, capability, or possibility associated with the qualified verb. Accordingly, usage of "may" and "may be" indicates that a modified term is apparently appropriate, capable, or suitable for an indicated capacity, function, or usage, while taking into account that in some circumstances the modified term may sometimes not be appropriate, capable, or suitable. For example, in some circumstances an event or capacity can be expected, while in other circumstances the event or capacity cannot occur - this distinction is captured by the terms "may" and "may be."

As used in the claims, the word "comprises" and its grammatical variants logically also subtend and include phrases of varying and differing extent such as for example, but not limited thereto, "consisting essentially of" and "consisting of." Where necessary, ranges have been supplied, and those ranges are inclusive of all sub-ranges therebetween. It is to be expected that the appended claims should cover variations in the ranges except where this disclosure makes clear the use of a particular range in certain embodiments.

## Claims

1. A furniture accessory (102) comprising:
an accessory body (104);
a controller (116) detachably coupled to the accessory body (104); and
a receptacle (128) extending through the accessory body (104) in a vertical direction and defining a cavity (904) within the receptacle (128), the receptacle (128) comprising a movable plate (1202) provided within the cavity (904);
wherein the controller (116) is configured to control a position of the movable plate (1202) in the vertical direction;
wherein the receptacle (128) comprises a receptacle upper rim surface (134); wherein the movable plate (1202) comprises a plate surface (132); and wherein in a state in which the movable plate (1202) is at an upper position limit in the vertical direction, the plate surface (132) is substantially coplanar with the receptacle upper rim surface (134) of the receptacle (128);
wherein the accessory body (104) comprises a body first surface (110) and a body second surface (112) displaced from the body first surface (110) in the vertical direction; wherein the controller (116) comprises a controller first surface (118) and a controller second surface (120) displaced from the controller first surface (118) in the vertical direction; and wherein in a state in which the movable plate (1202) is at an upper position limit in the vertical direction and the controller (116) is coupled to the accessory body (104), the plate surface (132) is substantially coplanar with the receptacle upper rim surface (134), the body first surface (110), and the controller first surface (118);
wherein the body second surface (112) is lower than the body first surface (110) in the vertical direction; and wherein in a state in which the controller (116) is coupled to the accessory body (104), the controller second surface (120) is lower than the controller first surface (118) in the vertical direction.

2. The furniture accessory (102) of claim 1, wherein the controller (116) comprises a user input (124) configured to control the position of the movable plate (1202) in the vertical direction.

3. The furniture accessory (102) of claim 1, wherein the movable plate (1202) further comprises a charging element (1320) configured to charge a user device via electromagnetic induction.

4. The furniture accessory (102) of claim 1, wherein the accessory body (104) is configured to electrically charge the controller (116) when the controller (116) is coupled to the accessory body (104).

5. The furniture accessory (102) of claim 1, wherein the controller (116) is configured to communicate with the accessory body (104) via wireless communication.

6. A furniture item (1302) comprising the furniture accessory of claim 1 and further comprising:
a function unit;
wherein the controller (116) is configured to control an operation of the function unit.

7. The furniture item (1302) of claim 6, wherein the movable plate (1202) further comprises a charging element (1320) configured to charge a user device via electromagnetic induction.

8. The furniture item (1302) of claim 6, wherein the accessory body (104) is configured to electrically charge the controller (116) when the controller (116) is coupled to the accessory body (104).

9. The furniture item (1302) of claim 6, wherein the controller (116) is configured to communicate with the accessory body (104) via wireless communication.

## Patentansprüche

1. Möbelzubehör (102), umfassend:
einen Zubehörkörper (104);
ein Steuergerät (116), das lösbar mit dem Zubehörkörper (104) gekoppelt ist; und
eine Aufnahme (128), die sich in einer vertikalen Richtung durch den Zubehörkörper (104) erstreckt und einen Hohlraum (904) innerhalb der Aufnahme (128) definiert; wobei die Aufnahme (128) eine bewegliche Platte (1202) umfasst, die innerhalb des Hohlraums (904) angeordnet ist;
wobei das Steuergerät (116) dazu eingerichtet ist, eine Position der beweglichen Platte (1202) in der vertikalen Richtung zu steuern;
wobei die Aufnahme (128) eine obere Randfläche (134) aufweist; wobei die bewegliche Platte (1202) eine Plattenfläche (132) aufweist; und wobei in einem Zustand, in dem sich die bewegliche Platte (1202) in einer oberen Endlage in der vertikalen Richtung befindet, die Plattenfläche (132) im Wesentlichen in derselben Ebene wie die obere Randfläche (134) der Aufnahme (128) liegt;
wobei der Zubehörkörper (104) eine erste Körperfläche (110) und eine zweite Körperfläche (112) aufweist, die gegenüber der ersten Körperfläche (110) in der vertikalen Richtung versetzt ist; wobei das Steuergerät (116) eine erste Steuergerätefläche (118) und eine zweite Steuergerätefläche (120) aufweist, die gegenüber der ersten Steuergerätefläche (118) in der vertikalen Richtung versetzt ist; und wobei in einem Zustand, in dem sich die bewegliche Platte (1202) in einer oberen Endlage in der vertikalen Richtung befindet und das Steuergerät (116) mit dem Zubehörkörper (104) gekoppelt ist, die Plattenfläche (132) im Wesentlichen in derselben Ebene wie die obere Randfläche (134), die erste Körperfläche (110) und die erste Steuergerätefläche (118) liegt;
wobei die zweite Körperfläche (112) in der vertikalen Richtung tiefer als die erste Körperfläche (110) liegt; und wobei in einem Zustand, in dem das Steuergerät (116) mit dem Zubehörkörper (104) gekoppelt ist, die zweite Steuergerätefläche (120) in der vertikalen Richtung tiefer als die erste Steuergerätefläche (118) liegt.

2. Möbelzubehör (102) nach Anspruch 1, wobei das Steuergerät (116) ein Benutzereingabeelement (124) umfasst, das dazu eingerichtet ist, die Position der beweglichen Platte (1202) in der vertikalen Richtung zu steuern.

3. Möbelzubehör (102) nach Anspruch 1, wobei die bewegliche Platte (1202) ferner ein Ladeelement (1320) umfasst, das dazu eingerichtet ist, ein Benutzergerät mittels elektromagnetischer Induktion aufzuladen.

4. Möbelzubehör (102) nach Anspruch 1, wobei der Zubehörkörper (104) dazu eingerichtet ist, das Steuergerät (116) elektrisch aufzuladen, wenn das Steuergerät (116) mit dem Zubehörkörper (104) gekoppelt ist.

5. Möbelzubehör (102) nach Anspruch 1, wobei das Steuergerät (116) dazu eingerichtet ist, drahtlos mit dem Zubehörkörper (104) zu kommunizieren.

6. Möbelstück (1302), umfassend das Möbelzubehör nach Anspruch 1 und ferner umfassend:
eine Funktionseinheit;
wobei das Steuergerät (116) dazu eingerichtet ist, einen Betrieb der Funktionseinheit zu steuern.

7. Möbelstück (1302) nach Anspruch 6, wobei die bewegliche Platte (1202) ferner ein Ladeelement (1320) umfasst, das dazu eingerichtet ist, ein Benutzergerät mittels elektromagnetischer Induktion aufzuladen.

8. Möbelstück (1302) nach Anspruch 6, wobei der Zubehörkörper (104) dazu eingerichtet ist, das Steuergerät (116) elektrisch aufzuladen, wenn das Steuergerät (116) mit dem Zubehörkörper (104) gekoppelt ist.

9. Möbelstück (1302) nach Anspruch 6, wobei das Steuergerät (116) dazu eingerichtet ist, drahtlos mit dem Zubehörkörper (104) zu kommunizieren.

## Revendications

1. Un accessoire de meuble (102) comprenant:
un corps d'accessoire (104);
un dispositif de commande (116) couplé de manière détachable au corps d'accessoire (104); et
un réceptacle (128) s'étendant à travers le corps d'accessoire (104) dans une direction verticale et définissant une cavité (904) à l'intérieur du réceptacle (128),
le réceptacle (128) comprenant une plaque mobile (1202) prévue à l'intérieur de
la cavité (904);
dans lequel le dispositif de commande (116) est configuré pour commander une position de la plaque mobile (1202) dans la direction verticale;
dans lequel le réceptacle (128) comprend une surface de rebord supérieur de réceptacle (134); dans lequel la plaque mobile (1202) comprend une surface de plaque (132); et dans lequel, dans un état dans lequel la plaque mobile (1202) est à une limite de position supérieure dans la direction verticale, la surface de plaque (132) est sensiblement coplanaire avec la surface de rebord supérieur de réceptacle (134) du réceptacle (128);
dans lequel le corps d'accessoire (104) comprend une première surface de corps (110) et une deuxième surface de corps (112) décalée de la première surface de corps (110) dans la direction verticale; dans lequel le dispositif de commande (116) comprend une première surface de dispositif de commande (118) et une deuxième surface de dispositif de commande (120) décalée de la première surface de dispositif de commande (118) dans la direction verticale; et dans lequel, dans un état dans lequel la plaque mobile (1202) est à une limite de position supérieure dans la direction verticale et le dispositif de commande (116) est couplé au corps d'accessoire (104), la surface de plaque (132) est sensiblement coplanaire avec la surface de rebord supérieur de réceptacle (134), la première surface de corps (110), et la première surface de dispositif de commande (118);
dans lequel la deuxième surface de corps (112) est plus basse que la première surface de corps (110) dans la direction verticale; et dans lequel, dans un état dans lequel le dispositif de commande (116) est couplé au corps d'accessoire (104), la deuxième surface de dispositif de commande (120) est plus basse que la première surface de dispositif de commande (118) dans la direction verticale.

2. L'accessoire de meuble (102) selon la revendication 1, dans lequel le dispositif de commande (116) comprend une entrée utilisateur (124) configurée pour commander la position de la plaque mobile (1202) dans la direction verticale.

3. L'accessoire de meuble (102) selon la revendication 1, dans lequel la plaque mobile (1202) comprend en outre un élément de charge (1320) configuré pour charger un appareil utilisateur par induction électromagnétique.

4. L'accessoire de meuble (102) selon la revendication 1, dans lequel le corps d'accessoire (104) est configuré pour charger électriquement le dispositif de commande (116) lorsque le dispositif de commande (116) est couplé au corps d'accessoire (104).

5. L'accessoire de meuble (102) selon la revendication 1, dans lequel le dispositif de commande (116) est configuré pour communiquer avec le corps d'accessoire (104) par communication sans fil.

6. Un article de meuble (1302) comprenant l'accessoire de meuble selon la revendication 1 et comprenant en outre:
une unité fonctionnelle;
dans lequel le dispositif de commande (116) est configuré pour commander un fonctionnement de l'unité fonctionnelle.

7. L'article de meuble (1302) selon la revendication 6, dans lequel la plaque mobile (1202) comprend en outre un élément de charge (1320) configuré pour charger un appareil utilisateur par induction électromagnétique.

8. L'article de meuble (1302) selon la revendication 6, dans lequel le corps d'accessoire (104) est configuré pour charger électriquement le dispositif de commande (116) lorsque le dispositif de commande (116) est couplé au corps d'accessoire (104).

9. L'article de meuble (1302) selon la revendication 6, dans lequel le dispositif de commande (116) est configuré pour communiquer avec le corps d'accessoire (104) par communication sans fil.
